(19) Europäisches Patentamt
European Patent Office
Office européen des brevets

(11) Publication number: 0 193 306 A2

(12) # EUROPEAN PATENT APPLICATION

(21) Application number: 86300947.8

(22) Date of filing: 12.02.86

(51) Int.Cl.[4]: G 06 F 12/06

(30) Priority: 28.02.85 US 706557

(43) Date of publication of application: 03.09.86 Bulletin 86/36

(84) Designated Contracting States: AT CH DE FR GB IT LI NL

(71) Applicant: WESTINGHOUSE ELECTRIC CORPORATION
Westinghouse Building Gateway Center
Pittsburgh Pennsylvania 15235(US)

(72) Inventor: Maxwell, Albert Herr, Jr.
6801 Justice Drive
Raleigh North Carolina 27609(US)

(72) Inventor: Doby, William Pinckney
4905 Will-O-Dean Road
Raleigh North Carolina 27604(US)

(74) Representative: van Berlyn, Ronald Gilbert
23, Centre Heights
London, NW3 6JG(GB)

(54) **Solid state memory cartridge.**

(57) A portable memory cartridge [Figures 1-3 (10) ] is provided with a plurality of memory storage devices [Figures 1, 3 (11-16); Figures 2, 3 (51-56)] along with a decoder [Figures 1, 2 (30)] that permits an external device (D1-D8) to address specific memory locations within the memory cartridge devices or individual capacities of the memory devices used within the memory cartridge. A connector (22) is connected in signal communication with each of the memory devices within the memory cartridge and a decoder (30) is used to determine the proper memory component applicable for a particular address received from an external device. The connection points (C1-C32) of the connector are divided into three sets. A first set [Figures 1, 2 (C1-C8)] represents binary digits of data. A second set [Figure 1 (C11-C21); Figure 2 (C11-C23)] represents the lower order bits of an address word and the third set [Figure 1 (C22-C24); Figure 2 (C24-C26)] represents the higher order bits of an address word which is used as an input to the decoder 30 which selects one of the plurality of memory devices in which the chosen memory location is located. The combined third and second binary digits represents a total address relative to the 0 location within the entire memory cartridge. The circuitry and memory devices are located within a plastic case that is made of an antistatic material to pre-vent inadvertent damage during insertion into an external device.



Croydon Printing Company Ltd.

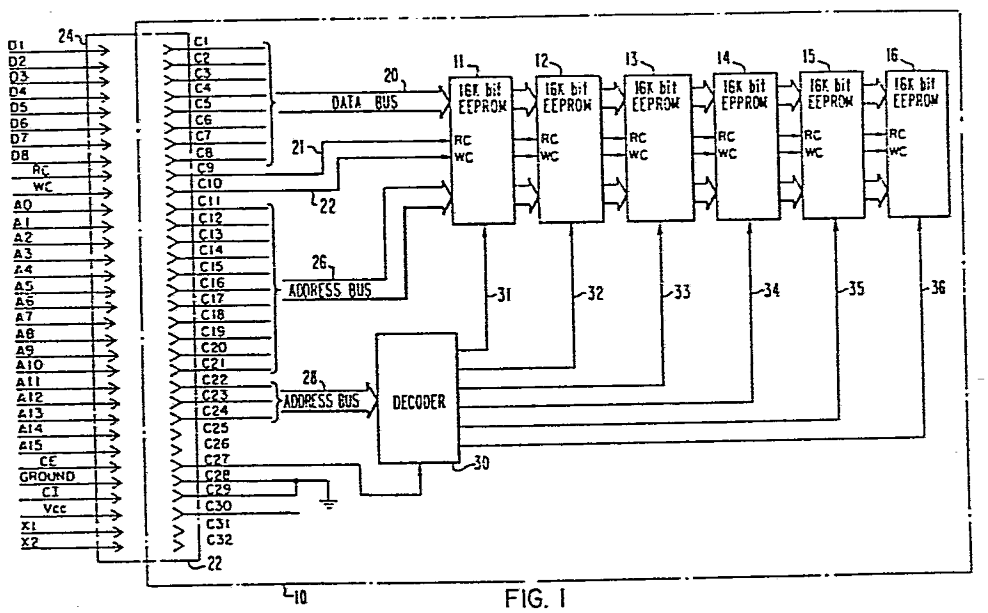
D1
D2
D3
D4
D5
D6
D7
D8
RC
WC
A0
A1
A2
A3
A4
A5
A6
A7
A8
A9
A10
A11
A12
A13
A14
A15
CE
GROUND
CI
Vcc
X1
X2
DATA BUS
ADDRESS BUS
ADDRESS BUS
DECODER
16K bit EEPROM
RC
WC

FIG. I

# SOLID STATE MEMORY CARTRIDGE

The present invention relates generally to solid state memory devices and, more particularly, to a memory cartridge for use with load survey recorders and translators.

Load research devices are used by electric utility companies to study and record a particular electric consumer's energy consumption characteristics. Typically, a load research device, which is commonly referred to as a load survey recorder or a mass data recorder, comprises a data recorder associated with a watthour meter and a pulse initiator or other impulse sending device. The watthour meter can be the consumer's watthour billing meter or a meter of a similar type. The meter typically generates the demand pulses which are recorded on a recording medium. One particular type of load survey recorder utilizes a magnetic tape recorder and a removable tape cartridge. United States Patents 4,063,661 and 4,115,835 which issued to Doby on December 20, 1977 and September 19, 1978, respectively, disclose a particular type of electric load research device including an enclosure having adjustable meter positions.

In load survey recorders that utilize magnetic tape as a storage medium, the recorder typically records both time and demand pulses on separate tracks of the magnetic tape. The timing pulses permit a translator to later analyze the recorded data as a function of time and determine the consumer's energy demand for each predetermined increment of time over a longer period of time, such as a billing period.

When a load survey recorder is used, a removable memory medium, such as a magnetic tape cartridge, is typically inserted into a recorder at the beginning of the billing period and removed at the end of the billing period. During the monitored period of time, the recorder causes the timing pulses and demand pulses to be recorded onto the magnetic tape, or alternative storage medium, and the consumer's demand profile is recorded throughout the recording period. At the end of the recording period, the memory medium is removed and transported to a translator.

The translator typically comprises a computer and a device capable of reading the recorded data, such as a magnetic tape reader. By reading the timing pulses and demand pulses, the translator can analyze the consumer's demand profile and provide survey information that can be used both by the electric utility and its customer. U.K. Letters Patent 1,339,276 (U.S. Patent No. 3,678,484 which issued to Maxwell on July 18, 1972) discloses a particular reverse-direction tape translation procedure.

Solid state memory cartridges represent significant advantages in comparison to magnetic tape cartridges. For example, magnetic tape can be susceptible to damage, such as creasing and rippling, because of its delicate structure. Furthermore, the recording and reading heads of tape recorders and readers can be adversely affected by residue that accumulates during long periods of time. This residue deleteriously affects the contact between the heads and the magnetic tape and reduces the signal strength of transmitted messages. This particular problem can cause valuable data to be lost.

The requirement of constant tape transport speed across the heads requires particular motors, capstan drive wheels, drive belts, reels and other components. These moving parts increase the cost of related equipment and can be the source of equipment failure.

Perhaps the most serious drawback of tape recording equipment is in its application to mass data recording systems. The entire tape must be reversed and played back at a much faster speed than that used in recording. Since the tape is, by its nature, a serial recording format, the entire tape must be read at one time. These factors seriously complicate the use of tape recording in systems where phone lines are to be used to transmit data as is required by many users of mass data recording systems. Solid state memory systems have no moving parts and permit individual data locations to be accessed independently.

In recent years, solid state memory components have been developed and utilized in many consumer and industrial applications. Some load survey recorders have been designed which utilize bubble memory cartridges to store the load survey information. The use of solid state memory devices in conjunction with load survey recorders avoids the need for magnetic tape cartridges and the problems incumbent with their use.

Since solid state technology is continually advancing, the potential for rapid obsolescence of solid state devices is significant. For example, development of larger and more compact memory components which significantly expand memory storage capacity for a given spatial requirement will make larger components with lower capacity obsolete. Since load survey recorders and translators are designed in association with particular memory media, changes in the technology relating to the memory media can adversely affect the recorders and translators and therefore require design changes to accommodate the more advanced and higher capacity memory devices.

The chief object of the present invention is to utilize the above technology basis to provide a memory cartridge whose maximum data storage capacity can be expanded without adverse affect on the design of either the recorder or translator used in conjunction with it so that the particular memory component to which data is written is transparent to the recorder or translator.

With this object in view, the invention resides in a solid state memory device, comprising: a plurality of means for storing digital information, each of said plurality of storing means having a predetermined memory capacity; a connector connected in signal communication with each of said plurality of storing means, said connector having a plurality of connection points comprising first, second and third sets of binary digits; said first set of binary digits being associated with data to be stored in a preselected one of said plurality of storing means; said second set of binary digits being associated with lower order address binary digits representing a preselected memory location in one of said plurality of storing means; said third set of binary digits being associated with higher order address binary digits representing a preselected one of said plurality of storing means; and means for selecting one of said plurality of storing means as a function of the status of said third set of binary digits, said selecting means being connected in signal communication with said third set of binary digits and each of said plurality of storing means; and means for defining the maximum capacity of said plurality of storing means.

The invention will become more readily apparent from the following exemplary description taken in conjunction with the accompanying drawing, in which:

Figure 1 illustrates a schematic diagram of one alternative embodiment of the present invention;

Figure 2 illustrates a second alternative embodiment of the present invention; and

Figure 3 is an exploded view of the physical construction of the present invention.

The present disclosure provides a memory cartridge whose maximum memory capacity can be changed without adversely affecting either the recorder or translator. The solid state memory cartridge itself comprises a plurality of solid state memory components, such as electrically erasable programmable read-only memories (EEPROM's), and, based on a standard address signal received from a recorder or translator, determines the proper component in which data should be written to or read from. The present invention also provides data which represents its own maximum memory capacity in such a way that an associated recorder or translator can easily determine the maximum quantity of data that can be stored in the cartridge.

When this memory cartridge is utilized, all address and data commands from recorders or translators are independent of the maximum memory capacity of each of the memory devices in the cartridge or the particular number of solid state memory components contained therein. For example, if an electric utility installs a number of recorders at customer locations and a translator at its central data processing location, it may begin its operation by utilizing a plurality of memory cartridges, for example, that each contain six solid state memory components with each individual component having a maximum capacity of 16,384 bits (i.e. 16K bits). In this type of application, the solid state memory cartridge would have a maximum capacity of 98,304 (i.e. 96K bits). If, due to advancements in technology, it becomes cost advantageous to utilize 64K bit components instead of 16K bit components, the electric utility may wish to replace its solid state memory cartridges with newer and more technologically advanced cartridges that contain six memory components of 64K bit capacity each. This would expand the total capacity of the cartridge to 384K bits. In a memory cartridge made in accordance with the present invention, these changes can be implemented without any required redesign of either the load survey recorders or the translator. Furthermore, the number of solid state memory components can be selected to be a number other than six.

The portable solid state memory cartridge also comprises an anti-static plastic case that is shaped to receive one or more substrates, such as printed circuit boards, in sliding relationship therein. The inner surfaces of the case are provided with slots that permit the substrates to slide into position and be contained by the attachment of a removable plate that encloses the present invention within the case. A plurality of solid state memory devices, such as EEPROM's, serve as means for storing digital information. Each of the memory devices is connected in signal communication with a connector that provides a means for electrically connecting the cartridge to an external device, such as a recorder or a translator. The connector also provides a number of individual connection points that are used for transmitting digital information between the solid state memory cartridge and either a recorder or a translator. A decoder is connected in signal communication with a preselected set of connection points of the connector. The decoder selects one of the plurality of memory components based on the value of inputs received from the connector.

A removable plate provides an opening through which the connector can be disposed in signal communication with a connector of the recorder or translator. The connector comprises a plurality of connection points that represent first, second and third sets of binary digits. The first set of binary digits are associated with data that is to be written to or read from the memory cartridge. Although eight connection points are used to transmit this first set of binary digits, alternative numbers of connection points can be used. A second set of binary digits is associated with the lower order address binary digits that represent a preselected memory location within the memory cartridge. A third set of binary digits are associated with the higher order address binary digits representing a preselected one of the plurality of memory components within the memory cartridge. The third set of binary digits are connected as inputs to the decoder and enable the decoder to properly select the particular one of the plurality of memory components associated with the address.

In order for the recorder and the translator to recognize the maximum memory capacity of the memory cartridge, means are provided for defining its maximum memory storage capacity. A predefined location in one of the memory components within the memory cartridge is used to permanently store a digital number representing the maximum storage capacity of the cartridge. When a new cartridge is installed in either a recorder or a translator, the recorder or translator first reads this stored capacity value. This value can be used as an upper limit to the amount of data that can be stored within the cartridge.

The storage capacity of memory cartridges can be expanded, according to thid disclosure, to take full advantage of advancements in solid state technology without the need for changing either the hardware or software design of the associated recorders and translators. Each memory cartridge therefor contains all of the electronic logic and information necessary to permit cartridges with expanded memory capacity to be used. Recorders and translators can thereby readily determine the capacity of each individual memory cartridge and read or write data accordingly. All address commands and data commands transmitted to, or read from, the memory cartridges are of an identical format regardless of the maximum memory capacity of the cartridge or the particular number or storage capacity of the solid state memory components used therein. The precise memory component to which data is written is transparent to the recorder or translator and the particular internal design of the memory components within the cartridge is not pertinent to either the recorders or the translator used in conjunction with it.

Figures 1 and 2 represent two alternative embodiments of the present invention and illustrate the advantages of flexibility that the present invention provides.

Figure 1 illustrates an exemplary design of the present invention in which six 16K bit memory components are utilized and Figure 2 illustrates an exemplary design of the present invention in which six 64K bit memory components are utilized.

In Figure 1, six 16K bit memory components, 11-16, are connected to each other in an electrically parallel configuration. Each of the six memory components, 11-16, has an individual memory capacity of 16K bits or 2K bytes. Throughout the discussion of the preferred embodiment of the present invention, simplified memory capacity terminology will be utilized. For example, although each of the memory components in Figure 1 has an actual capacity of 16,384 bits or 2,048 bytes, these memory capacities will be referred to as "16K bits" or "2K bytes", respectively. In a preferred embodiment of the present invention, these 16K bit memory components are style no. X2816GAPI-45which are available in commercial quantities from XICOR Inc. This particular device is an EEPROM, sometimes referred to as an "E-square PROM", which provides a reliable non-volatile memory storage medium.

Each of the memory components is connected, by data bus 20, to eight connection points of a connector 22. These eight connection points, C1-C8, provide a means for transmitting eight data bits in parallel to the present invention. The connector 22 of the present invention is shaped to receive a mating connector 24 that is connected to a load survey recorder or translator. In a preferred embodiment of the present invention, the connector 22 is style no. FCN-365J032-AV which is available in commercial quantities from Fujitsu America Inc. The mating connector 24, which is not part of the present invention, but is utilized in association with connector 22, is style no. FCN-364P032-AV which is available in commercial quantities from Fujitsu America Inc.

The connection points of connector 24 are attached to either a recorder or translator. Eight of its connection points, D1-D8, are used to transmit data from its associated recorder, or translator, to connection points C1-C8 of the present invention. When connectors 22 and 24 are associated together in signal communication, the binary digits of connection points D1-D8 are connected in signal communication with each of the memory devices, 11-16. Two connection points, RC and WC, of connector 24 are associated with connection points C9 and C10 of connector 22 and provide "read control" and "write control" signals, respectively, to the memory components, 11-16.

The connector 24 also has a plurality of connection points, A0-A15, which represents address values associated with the particular memory location, or byte, in which data is to be written to or read from. As can be seen in Figure 1, connection points A0-A10 are associated with connection points C11-C21 of connector 22. The binary digits associated with these connection points represent the lower order address bits of a particular address within the memory of the present invention. It should be understood that these lower order bits do not contain information which can be used to determine the precise memory component associated with the desired memory location. Connection points A11-A13 of connector 24 are associated with connection points C22-C24 of connector 22 and represent the higher order binary digits of the memory address. These higher order binary digits are connected in signal communication with a decoder 30 by address bus 28. The decoder 30 receives, as its inputs on address bus 28, the binary value represented by connection points C22-C24 and, based on this value, selects the proper memory component of the six available devices, 11-16. In a preferred embodiment of the present invention, the decoder is type 74HC138 which is available in commercial quantities from National Semiconductor Corp. Based on the information received from address bus 28, the decoder 30 provides a signal on one of the chip select lines, 31-36, to activate the proper one of the memory components, 11-16.

Since the lower order binary digits, on address bus 26, are connected in signal communication with all of the memory components, the decoder 30 can utilize the information from address bus 28 to properly select the precise memory location represented by the combined address bits, A0-A13, transmitted to the solid state memory cartridge 10 of the present invention. As can be seen from Figure 1, the sender of the address bits (e.g. a load survey recorder or translator) need not know the precise memory component in which the data is stored. It merely transmits an address on its address connection points, A0-A13, and the decoder 30, in combination with the memory components 11-16, determines the proper memory location in which the data will be stored. The address transmitted by the load survey recorder or translator, on connection points A0-A13, merely represents a location relative to the first location of the first memory component 11. Therefore, the transmitting device need not know the number of memory components or the maximum memory capacity of each component within the memory cartridge 10 of the present invention.

It should be understood that connection points A14 and A15 of connector 24 in Figure 1 are associated with connection points 25 and 26 of connector 22 which are not utilized in this illustration. The address binary digits A14 and A15 are provided for association with memory cartridges that have more than 96K bits of memory capacity. In addition to the connection points described above, connector 24 also provides a "cartridge enable" signal CE, a circuit ground, a "cartridge inserted" signal CI and a regulated voltage supply VCC which are associated with connection points C27-C30, respectively, of connector 22. Connection points X1 and X2 of connector 24 are associated with connection points C31 and C32 of connector 22 and are not used in this embodiment of the present invention.

Figure 2 illustrates an alternative embodiment of the present invention in which each of the memory devices, 51-56, has a 64K bit capacity. In this embodiment of the present invention, each of these memory devices can be style X2864A which is an EEPROM available in commercial quantities from XICOR Inc. It should be apparent that, since each of the memory devices, 51-56, has a greater capacity than the memory devices, 11-16, illustrated in Figure 1, the addressing scheme must be different than that illustrated in Figure 1.

As illustrated in Figure 2, address bus 60 provides signal communication between the memory devices and connection points C11-C23 of connector 22. These connection points of connector 22 are associated with connection points A0-A12 of connector 24. Although somewhat similar to the connection point association illustrated in Figure 1, it should be noted that the connection points associated with address bus 60 are of a larger number than that illustrated in Figure 1. For example, in Figure 2 there are 13 binary digits associated with the lower order bits of the address that is connected in signal communication with the memory devices, 51-56, as compared to only 11 binary digits of the lower order bits in the address connected to the address bus 26 in Figure 1. The reason for this difference is that each memory device in Figure 2 has a larger capacity than the corresponding memory device in Figure 1. More particularly, in these examples each memory device in Figure 2 actually has four times the storage capacity of each memory device in Figure 1.

Connection points A13-A15 of connector 24 are associated with connection points C24-C26 of connector 22 and these connection points relate to the higher order address bits of the address. These higher order binary digits are connected in signal communication, by address bus 62, to the decoder 30.

In the manner described above, in conjunction with the description of the decoder 30 in Figure 1, the decoder 30 in Figure 2 receives a binary value from address bus 62 and selects the proper memory device, 51-56, associated with that binary value. After selecting the proper memory device, the decoder 30 outputs a signal to the proper memory device on one of the chip select lines, 71-76, corresponding to that memory device.

Connection points CE, ground, CI, $V_{CC}$, X1 and X2 of connector 24 are associated with connection points C27-C32 of connector 22 in a manner similar to that described above in conjunction with Figure 1.

A comparison of Figures 1 and 2 will illustrate the advantage of the present invention. By outputting an address on connection points A0-A15, an external device such as a load survey recorder or translator can communicate with the memory storage of the present invention without concern with the particular memory device, 11-16 or 51-56, in which the data will be stored. Any address transmitted to connection points A0-A15 will be properly routed to its corresponding memory device regardless of the number of memory devices utilized or the maximum storage capacity of each individual memory device. If the address transmitted to connection points A0-A15 is within the maximum allowable capacity of the memory cartridge 10, the data from connection points D1-D8 will be properly written to or read from the memory cartridge.

Table I shows the component values or types utilized in the embodiments of the present invention illustrated in Figures 1 and 2. It should be understood that alternative component styles and values can be used in accordance with the present invention.

TABLE I

| Reference Numeral | Component Value or Type |
|---|---|
| 11 | 2K x 8 EEPROM IC |
| 12 | 2K x 8 EEPROM IC |
| 13 | 2K x 8 EEPROM IC |
| 14 | 2K x 8 EEPROM IC |
| 15 | 2K x 8 EEPROM IC |
| 16 | 2K x 8 EEPROM IC |
| 22 | 32 Pin Socket |
| 24 | 32 Pin Plug |
| 30 | 74 HC138 Decoder 1C |
| 51 | 8K x 8 EEPROM 1C |
| 52 | 8K x 8 EEPROM 1C |
| 53 | 8K x 8 EEPROM 1C |
| 54 | 8K x 8 EEPROM 1C |
| 55 | 8K x 8 EEPROM 1C |
| 56 | 8K x 8 EEPROM 1C |
| 96 | 15, 47K Ω Resistor Pack |
| 97 | 15, 47K Ω Resistor Pack |
| 98 | 10 K Ω Resistors |
| 100 | 1 wfd Capacitor |
| 102 | 0.01 ufd Capacitor |
| 106 | 15 Pin Plug |
| 110 | 15 Pin Socket |
| 112 | 15 Pin Socket |

Table II illustrates examples of typical addresses transmitted, as binary digits, to connection points A0-A15 of connector 24 by an associated load survey recorder or translator. Each of the columns representing connection points of connector 24 (e.g. A0, A1,....A15) is also labeled with the associated connection point of connector 22 (e.g. C11, C12,....C26). Each of the items in Table II represents an exemplary address for purposes of further explaining the addressing structure of the present invention. The items in Table II will be utilized, below, to explain the address routing of both higher order and lower order binary digits in the embodiments illustrated in Figures 1 and 2.

TABLE II

ADDRESS DECODING

| ITEM | A15 C26 | A14 C25 | A13 C24 | A12 C23 | A11 C22 | A10 C21 | A9 C20 | A8 C19 | A7 C18 | A6 C17 | A5 C16 | A4 C15 | A3 C14 | A2 C13 | A1 C12 | A0 C11 | CONTENTS (HEX) | CONTENTS (DEC) |
|---|---|---|---|---|---|---|---|---|---|---|---|---|---|---|---|---|---|---|
| 1 | 0 | 0 | 0 | 0 | 0 | 0 | 0 | 0 | 0 | 1 | 0 | 0 | 1 | 1 | 1 | 1 | 004F | 79 |
| 2 | 0 | 0 | 0 | 0 | 0 | 1 | 0 | 1 | 0 | 0 | 0 | 0 | 1 | 1 | 0 | 0 | 050C | 1,292 |
| 3 | 0 | 0 | 0 | 0 | 0 | 1 | 1 | 1 | 1 | 1 | 1 | 1 | 1 | 1 | 1 | 1 | 07FF | 2,047 |
| 4 | 0 | 0 | 0 | 0 | 1 | 0 | 0 | 0 | 0 | 0 | 0 | 0 | 0 | 0 | 0 | 0 | 0800 | 2,048 |
| 5 | 0 | 0 | 0 | 0 | 1 | 0 | 0 | 0 | 0 | 1 | 0 | 0 | 1 | 1 | 1 | 1 | 084F | 2,127 |
| 6 | 0 | 0 | 1 | 0 | 1 | 0 | 0 | 0 | 0 | 1 | 0 | 0 | 1 | 1 | 1 | 1 | 284F | 10,319 |
| 7 | 0 | 0 | 1 | 0 | 1 | 1 | 1 | 1 | 1 | 1 | 1 | 1 | 1 | 1 | 1 | 1 | 2FFF | 12,287 |
| 8 | 0 | 0 | 1 | 0 | 0 | 0 | 0 | 0 | 0 | 0 | 0 | 0 | 0 | 0 | 0 | 0 | 2000 | 8,192 |
| 9 | 0 | 0 | 0 | 1 | 1 | 1 | 1 | 1 | 1 | 1 | 1 | 1 | 1 | 1 | 1 | 1 | 1FFF | 8,191 |
| 10 | 1 | 0 | 1 | 0 | 0 | 0 | 0 | 0 | 0 | 0 | 0 | 0 | 1 | 0 | 1 | 0 | A3F2 | 41,970 |

Item 1 illustrates an address represented by the binary digits equivalent to a hexadecimal X'004F'. This number is equivalent to a decimal 79, as illustrated in Table II, and represents the 80th memory location of the memory cartridge 10. Throughout this discussion, conventional binary terminology will be used in which each location is numbered from 0 to N, where N represents the maximum storage capacity of either a memory component or the entire memory cartridge. For example, each memory component has a "zeroth" location. Furthermore, each memory cartridge has a "zeroth" memory component, such as illustrated by reference numerals 11 and 51 in Figures 1 and 2, respectively. Referring to Figure 1, each of the memory components, 11-16, has 16K bits or 2K bytes. More precisely, the 2,048 bytes in each of the memory devices will be referred to as being numbered from byte zero to byte 2,047. Also, memory device 11 will be referred to as the "zeroth" device or device zero, memory device 12 will be referred to as device one, etc.

Referring to Table II, the address shown as item 1 refers to the 80th byte or byte number 79 in the memory cartridge. In both Figures 1 and 2, byte seventy-nine would be located in the "zeroth" memory component which are illustrated as reference numerals 11 and 51 in Figures 1 and 2, respectively. Since address connection points A11-A13 are all equal to zero, the decoder 30 would select the "zeroth" memory device 11 in Figure 1. Similarly, since address connection points A13-A15 are zero, the "zeroth" memory device 51 would be selected by the decoder 30 in Figure 2. Therefore, regardless of the particular configuration (i.e. Figures 1 or 2), the "zeroth" memory device would be selected by the decoder 30. As a further example of the addressing scheme, item 2 in Table II represents, in its lower order bits, the hexadecimal address X'050C' which is equivalent to memory location 1,292. Since the higher order bits, A11-A15, are all set to zero, the "zeroth" memory device in either embodiment would be selected by the decoder 30.

Item 3 in Figure 2 represents an address of hexadecimal X'07FF', or decimal 2047, which is associated with the last memory location in memory device 11 of Figure 1. As can be seen in these examples, the addresses shown as items 1, 2 and 3 in Table II all represent memory locations that are located in the "zeroth" memory device in any embodiment which comprises memory devices of 2K bytes or more.

Item 4 in Table II illustrates an address which would be treated differently in the two alternative embodiments illustrated in Figures 1 and 2. The address, which is a hexadecimal X'0800' or decimal 2048, has a binary 1 at connection point A11. Referring to Figure 1, connection points A11 and C22 are associated with the address bus 28 which transmits the higher order address bits to the decoder. If memory devices of 2K bytes each are utilized, as shown in Figure 1, the connection points C22-C24 contain a binary "001" which would cause the decoder 30 to send a signal on chip select line 32 to memory device one 12. The address illustrated as item 4 in Table II represents location 2,048 within the memory cartridge or the "zeroth" location in memory device 12. Referring now to Figure 2, it can be seen that the internal configuration of the memory cartridge 10 would treat the address shown as item 4 differently because of the use of memory devices, 51-56, which each has a memory capacity of 8K bytes. More specifically, since connection points A13-A15 and C24-C26 are zero, the decoder 30 would transmit a signal on chip select lines 71 to memory device 51 and location 2,048 in that memory device 51 would be addressed. From these examples, it should be understood that the decoder 30, in conjunction with the address bits connected its input address bus, reference numerals 28 or 62 in Figures 1 or 2, respectively, will select the memory device based on the individual maximum capacities of the memory devices utilized in the particular embodiment of the present invention. Since the higher order bits of the address connection points A0-A15 are used by the decoder 30, the transmitting device, such as a load survey recorder or translator, need not know the exact configuration within the memory cartridge 10 and the memory device selection is therefore transparent to it.

Item 5 in Table II is another example of an address which would be treated differently by the two embodiments illustrated in Figures 1 and 2. The address is a hexadecimal X'084F' which represents the location 2,127 within the memory cartridge 10. In Figure 2, this address would be directed to location 2,127 within memory device zero 51. However, in the embodiment illustrated in Figure 1, this address would represent memory location 79 in the first memory device 12. Item 7 of Table II illustrates an address that is equivalent to a hexadecimal X'2FFF' or memory location 12,287 within the memory cartridge 10. Looking at address connection points A11-A13 in Figure 1 and Table II, it can be determined that the binary value transmitted on address bus 28 to the decoder 30 is equivalent to "101" (i.e. a decimal 5). With this input, decoder 30 would select memory device five 16 and transmit a signal on chip select line 36. Location 79 of memory device five 16 would be the memory location addressed by this configuration of binary digits received at connection points C11-C21 of connector 22. Similarly, the address shown as item 7 in Table II would cause the decoder 30 to select memory device five 16 and would select location 2,047 within memory device five 16 shown in Figure 1. The address illustrated as item 7 in Table II represents the last available address in the memory cartridge illustrated in Figure 1.

Referring to Figure 2, items 6 and 7 in Table II would cause the decoder to select memory device one 52 by transmitting a signal on chip select line 72. This occurs because the higher order address bits A13-A15 contain a binary "001" which is transmitted along address bus 62 to the decoder and represents a selection of the memory device one 52.

Items 8 and 9 in Table II illustrate the addresses that would cause the decoder 30 to select the "zeroth" location of memory device 52 and location 8,191 of the "zeroth" memory device 51, respectively. Although these two memory locations are consecutive in the memory cartridge 10, they are stored in different memory devices in a manner that is transparent to the load survey recorder or translator that is communicating with the memory cartridge 10. As a last illustration, Item 10 of Table II illustrates an address configuration that would direct the data to or from the location 110 in memory device five 56 illustrated in Figure 2. Since address bits A13-A15 contain a binary "101", or 5, the decoder 30 would transmit a signal on chip select line 76 in response to receipt of these higher order bits on address bus 62.

These examples, illustrated in Table II, show the different results that can be obtained in response to similar address signals received from an external device. They further illustrate the fact that the external device, such as a recorder or translator, need not know the internal configuration of the memory cartridge 10 of the present invention. This permits different types of memory cartridges to be utilized with the same load survey recorders and translators without requiring design changes in either the hardware or software within those devices.

The only information needed by the transmitting device is a single digital value representing the highest available memory storage location of the cartridge. This information is provided by storing the digital value representing the maximum storage capacity of the cartridge in a preselected known location of the first memory device within the cartridge. This is possbible because of the nonvolatile nature of the solid state memory which, in this particular embodiment, is EEPROM.

Many data storage techniques are available and known to those skilled in the art. These techniques define a particular arrangement of data that is preselected and followed consistently by external devices that are writing to or reading from any mass data storage medium. In a particular embodiment of the present invention, a specific data storage technique is utilized. It should be understood that alternative data storage techniques are within the scope of the present invention. This particular data storage technique will be described in detail herein in order to fully describe the concept of containing the maximum storage capacity of the memory cartridge as a digital value within its first memory device.

When the memory cartridge of the present invention is installed in a load survey recorder at a consumer's location, the load survey recorder periodically transmits the energy demand data to the memory cartridge for storage. In order to accurately record this data in a manner which can readily be read by a translator at a later time, a preselected format must be used. Tables III, IV and V illustrate a particular format chosen for use with the preferred embodiment of the present invention. Table III illustrates the format of a header record used to identify the load survey recorder which transmits data to the memory cartridge.

TABLE III

HEADER RECORD

| ITEM | WORD | DESCRIPTION |
|---|---|---|
| HFLG | 0 | flag, start of header record |
| CSER | 1-3 | cartridge serial number (2 BCD digits) |
| FMAT | 4 | memory format spec code |
| TRFLG | 5 | translation flag, initially and after translation, N = 0. |
| | | When cartridge is inserted, recorder tests for N = 00. |
| | | If false: error |
| | | If true: recorder writes N=FF and proceeds. |
| MODFLG | 6 | binary count of number of constant revisions in ram |
| ID | 7-20 | alphanumeric characters for identifier |
| INTDEF | 21 | interval definition |
| | | = 00 for 5 min. intervals |
| | | = 01 for 15 min. intervals |
| | | = 03 for 30 min. intervals |
| | | = FF for any other interval length |
| CHDEF1 | 22 | active channel designators |
| CHDEF2 | 23 | encoding registers channel designators |
| LOPLIM | 24 | binary count indicating minimum time for a reportable outage; actual time = N * 2 secs. |
| PHONE | 25-31 | phone number for dial-in use |
| SHARES | 32-34 | for future use |
| INTLEN | 35 | interval length, any factor of 60 (01-60) |
| MEMSIZE | 36 | capacity of data ram in 1 K (1024) byte units |
| CARTSIZE | 37 | EEPROM cartridge size in 1 K (1024) byte units |
| SSPEC | 38-42 | most significant digit of Software Spec. No. (BCD) |
| | | 2nd and 3rd digits of S-Spec. No. |
| | | 4th and 5th digits of S-Spec. No. |
| | | group number of S-Spec. No. |
| | | Ascii code for S-Spec. revision level |
| IRTS | 43 | seconds, time of cartridge installation |
| ITRM | 44 | minutes, time of cartridge installation |
| ITRH | 45 | hours, time of cartridge installation |
| IRTD1 | 46 | day-of-month of cartridge installation (BCD) |
| IRTD2 | 47 | time of cartridge installation |
| | | bits 7-6: leap year count in binary |
| | | 5: 0 for STD time, 1 for DST |
| | | 4: 0 |
| | | 3-0: month count in hex |
| CSFLG | 48 | check sum flag |
| CHKSUM | 49 | binary sum of above locations (carries discarded) |
| TOTAL | 50 | (600 bits) |

In Table III, the header record consists of 600 bits, or 50 twelve-bit words, of data that identifies basic information relating to the demand data contained elsewhere in the memory cartridge. The header record contains many different types of information, as illustrated in Table III, that can be used when analyzing the demand data. One particular location in the header record is critically important to the present invention. Word thirty-seven in the header record, which is identified by the name "CARTSIZE", contains the cartridge size in 1 K byte units. This is the digital representation, referred to above, that contains the maximum storage capacity of the memory cartridge. When a new cartridge is inserted into either a load survey recorder or a translator, that external device first reads the 37th word of the header in order to determine the memory capacity limitation of the cartridge. The other words in the header are explained in the description within Table III and it should be understood that the particular locations and contents within the header record is not a limitation to the present invention but can vary depending on particular design considerations. In a preferred embodiment of the present invention, the header record is stored in the first portion of the "zeroth" memory component (e.g. components 11 and 51 in Figures 1 and 2, respectively).

Table IV illustrates the format of a marker record used in conjunction with the present invention. It contains 720 bits, or 60 twelve-bit words, is used to define certain events that occur during the recording period during which the energy demand data is being recorded. Marker records are written into the memory locations of the memory cartridge to identify certain important events. For example, a marker record would be written to record the exact time when the cartridge was installed in a load survey recorder. Marker records are also written when an operator depresses a "cartridge change" button for the purposes of changing memory cartridges in the mass data recorder. A marker recrod is also written when the recorder is remotely interrogated by some external device, such as a data retrieval request via a telephone line.

TABLE IV

MARKER RECORD

| ITEM | WORD | DESCRIPTION |
|---|---|---|
| MFLG | 0 | flag, start of marker record |
| MCNT | 1 | binary count of number of marker records written since cartridge installation, 0 < N < 256 |
| RTS | 3 | minutes, |
| RTM | 4 | hours, |
| RTD1 | 5 | day of month, |
| RTD2 | 6 | month and leap year count, |
| ETS | 7 | seconds, external clock time of recorder |
| ETM | 8 | minutes, |
| ETH | 9 | hours, |
| ETD1 | 10 | day of month, |
| ETD2 | 11 | month and leap year count, |
| ENCA | 12 | channel A encoding register reading, register flags, ten thousands digit |
| | | channel A encoding register reading, thousands, hundreds |
| | | channel A encoding register reading, tens, units |
| | | channel A encoding register reading, tenths, hundredths |
| ENCB | 16-19 | channel B encoding register reading, see ENCA |
| ENCC | 20-23 | channel C encoding register reading, see ENCA |
| ENCD | 24-27 | channel D encoding register reading, see ENCA |
| ENCER | 28 | flag bits, set on transmission error between EWR and encoder |
| REGA | 29 | channel A visual register reading, digit 5 (MS) |
| | 30 | channel A visual register reading, digit 4, digit 3 |
| | 31 | channel A visual register reading, digit 2, digit 1 |
| REGB | 32-34 | channel B visual register reading, see REGA |
| REGC | 35-37 | channel C visual register reading, see REGA |
| REGD | 38-40 | channel D visual register reading, see REGA |
| SDERR1 | 41 | self test diagnostic error message, bit set for |
| | | bit 0: rom checksum error |
| | | 1: ram checksum error |
| | | 2: battery failure |
| | | 3: unused |
| | | 4: hardware clock read error |
| | | 7-5: not used, set to 0 |
| STMESS1 | 42 | status message, bit set to 1 for status |
| | | bit 0: manual cartridge change used |
| | | 1: HT-10 terminal used for cartridge change |
| | | 2: ram buffer has overflowed or been initialized |
| | | 3: time or date reset |
| | | 4: marker due to remote interrogation request |
| | | 7-5: not used, set to 0 |
| SPARES | 43-57 | for future use |
| CSFLG | 58 | checksum flag |
| CHKSUM | 59 | binary sum of above locations (carries discarded) |
| TOTAL | 60 (720 bits) | |

Table V illustrates a typical format used to record data in the memory of the cartridge. The zeroth word of each data record begins with a start data flag, equivalent to hexadecimal X'FFE', and ends with a checksum flag equivalent to a hexadecimal X'FFA' followed by an 8-bit binary sum of all of the above locations within the data record. Each time an additional demand pulse count is recorded within a data record, the binary sum of all of the pulse counts is updated in RAM at this location and is written to the cartridge at the end of the data record.

TABLE V

DATA RECORD

| WORDS | FORMAT | DESCRIPTION |
|---|---|---|
| 0 | FFE | start data flag |
| 1 | NNN | A channel demand pulse count |
| 2 | NNN | A channel demand pulse count |
| . | ... | .... |
| . | ... | .... |
| . | ... | .... |
| . | ... | .... |
| . | ... | .... |
| . | ... | .... |
| . | ... | .... |
| . | ... | .... |
| . | ... | .... |
| . | ... | .... |
| N-1 | FFA | checksum flag |
| N | ONN | binary sum of above locations (carries discarded) |

When the memory cartridge is removed from the load survey recorder at the end of a recording period, it is transported to a central location where a translator is located. The memory cartridge is then inserted into the translator and appropriate software in the translator reads all of the memory locations within the memory cartridge. Since the load survey recorders and the translator all follow the same format of header record, marker records and data records, the demand history of the associated load survey recorder, from which the memory cartridge was removed, can be accurately tabulated and analyzed. Upon initial installation of the memory cartridge in a translator, the translator would first read location thirty-seven of the header record to determine the maximum capacity of the memory cartridge. Using this digital value, the translator can determine the maximum amount of data that can be read from the cartridge.

The present invention can be embodied in various physical configurations. Figure 3 illustrates a preferred embodiment of the present invention. The memory cartridge 10 comprises a plastic case 80 which is made of an anti-static plastic. This plastic case 80 is made with a conductive plastic in order to prevent potential electrostatic discharge (ESD) damage from occurring when the memory cartridge 10 is connected to an external device. The case 80 can also contain a slot 82 in its outer surface in order to facilitate alignment with an external device such as a load survey recorder or translator. A cover 84 is provided that fits onto the open end 86 of the case 80. In a preferred embodiment of the present invention, the cover 84 is further provided with holes 88 that are positioned in such a way so as to permit the cover 84 to be attached to the case 80 by a plurality of screws. In order to facilitate this attachment, the case 80 is provided with a plurality of holes 89 into which the screws can be fastened in such a way so as to firmly attach the cover 84 to the case 80.

As discussed in detail above, the present invention can utilize memory devices of different capacities. Therefore, the memory devices illustrated in Figure 3 are identified by dual reference numerals that coincide with the reference numerals used in conjunction with Figures 1 and 2. These dual reference numerals (e.g. 11, 51) represent an alternative selection of memory storage devices. The memory devices, 11-16 or 51-56, are rigidly attached to a substrate. In Figure 3, three memory devices are attached to substrate 90 and the remaining three memory devices are attached to substrate 92. It should be recognized that a single substrate could be used in alternative embodiments of the present invention.

As illustrated in Figure 3, a third substrate 94 is used to support other electronic components. For example, the decoder 30 and resistor packages 96 and 97 and connector 22 are supported by substrate 94. Similarly, resistor 98 and capacitors 100 and 102 are attached to substrate 94. It should be understood that although no circuit board runs are illustrated in Figure 3, appropriate electrical connections are provided between the electronic components of the present invention. These specific circuit board runs are dependent on the particular application and component selection utilized in the memory cartridge 10. In any event, the runs on the substrates, 90, 92 and 94, would reflect the circuitry illustrated in Figures 1 or 2. The bottom substrate 92 is provided with connectors 106 which comprise a plurality of pins 108. In a preferred embodiment of the present invention, a connector 106 of style 1100-1-115-08, which is available in commercial quantities from Methode Electronics Inc., is used. On substrate 94, connectors 110 are disposed at such a location so as to permit the pins 108 to pass through them. Similarly, connectors 112 are attached to substrate 90 that also permit pins 108 to pass through them. The pins 108 are passed through connectors 110 and 112 in order to provide parallel connection between the substrates, 90, 92 and 94. This type of connection provides the parallel interconnections between the memory devices and the other electronic components of the present invention. They pass through connectors 110 and 112, in a preferred embodiment of the present invention, are style no. 4455-BC which are available in commercial quantities from MOLEX.

Attached to substrate 94, is connector 22 which contains the connection points C1-C32 described in detail above. As can be seen in Figure 3, the cover 84 is provided with an opening 120 which is shaped to receive a portion of the connector 22. The opening 120 permits an external device to be connected to the present invention by being associated with connector 22 as connector 24 is associated with connector 22 in the illustrations of Figures 1 and 2.

When substrates 90, 92 and 94 are associated together and the pins 108 are inserted through connectors 110 and 112, these three substrates form a configuration which can be inserted into the case 80. Furthermore, the extensions 124 and 126 are shaped to provide slots to receive the three substrates in sliding relationship therein. This permits the configuration of substrates to be inserted into the case 80 while providing proper alignment between the connector 22 and the opening 120 in the cover 84. When assembled as described above, the memory cartridge 10 provides a durable memory medium which can be transported to the field for insertion into load survey recorders and returned to a central location for insertion into a translator for the purposes of recording and analyzing data, respectively. As can be seen in Figure 3, the outer surface of the case 80 is also provided with ridges 130 to facilitate gripping the cartridge.

In a preferred embodiment of the present invention, the memory devices, 11-16 or 51-56, are electrically erasable, programmable, read only memory (EEPROM) modules. Many different types and sizes of EEPROM devices are available. This particular type of solid state memory device provides a non-volatile storage medium. As new technology provides higher capacity EEPROM's, these devices can be utilized within the scope of the present invention to provide higher capacity memory cartridges.

The present invention provides a flexible memory device that is portable and rugged for repeated use in both the field and laboratory settings. It can easily be expanded to utilize larger memory capacity devices and can be addressed by external devices in a manner which is transparent to the actual number and capacity of individual memory components utilized within its structure.

This copy with reference numerals inserted, is enclosed in order to assist you in interpreting and/or translating the claims, as required



CLAIMS:

1. A solid state memory device [Figs. 1-3 (10)], comprising:

a plurality of means [Figs. 1, 3 (11-16); Figs. 2, 3 (51-56)] for storing digital information, each of said plurality of storing means having a predetermined memory capacity;

a connector (22) connected in signal communication with each of said plurality of storing means, said connector having a plurality of connection points (C1-C32) comprising first, second and third sets of binary digits;

said first set of binary digits being associated with data [Figs. 1, 2 (C1-C8) with D1-D8)] to be stored in a preselected one of said plurality of storing means;

said second set of binary digits being associated with lower order address [Fig. 1 (C11-C21); Fig. 2 (C11-C23)] binary digits representing a preselected memory location in one of said plurality of storing means; and characterized in that:

said third set of binary digits being associated with higher order address [Fig. 1 (C22-C24); Fig. 2 (C24-C26)] binary digits representing a preselected one of said plurality of storing means; and

means [Figs. 1, 2 (30)] for selecting one of said plurality of storing means as a function of the status of said third set of binary digits, said selecting means being connected [Fig. 1 (31-36); Fig. 2 (71-76)] in signal communication with said third set of binary digits and each of said plurality of storing means; and

means [TABLE III] for defining the maximum capacity of said plurality of storing means.

2. The device as claimed in claim 1, wherein:

said selecting means is a decoder having said third set of binary digits connected as inputs and a plurality of select lines connected as outputs, each of said plurality of select lines being connected to a preselected one of said plurality of storing means.

3. The device as claimed in claim 1 or 2, wherein:

said defining means is a preselected memory location [TABLE III (WORD 37)] set to contain a digital value representative of the maximum capacity of said plurality of storing means.

4. The device as claimed in claim 1, further comprising:

a boxlike container [Fig. 3 (80, 84)] shaped to receive said plurality of storing means and said selecting means, said container having an opening (120) in a preselected one of its sides (84), said opening being proximate said connector and being shaped to permit an external connection device (24) to be associated in signal communication with said connector.

5. The device as claimed in claim 4, wherein:

said container has an alignment slot (82) in a preselected one of its sides.

6. The device as claimed in claim 4 or 5, further comprising:

a substrate [Fig. 3 (90 or 92)] attached to said plurality of storing means; and

means (124) for receiving said substrate in sliding association with said container.

7. The device as claimed in any one of claims 4, 5, or 6 wherein:

said container is made of conductive plastic.

8. The device as claimed in claim 1 or 4, wherein:

each of said plurality of storing means is an electrically erasable programmable read only memory device.

9. A memory cartridge, comprising:

means [Figs. 1, 3 (11-16); Figs. 2, 3 (51-56)] for storing digital information;

a connector (22) connected in signal communication with said storing means, said connector having a plurality of connection points (C1-C32) comprising first, second and third sets of connection points associated with first, second and third sets of binary digits;

said first set of binary digits [Figs. 1, 2 (C1-C8)] representing data [Figs. 1, 2 (D1-D8)] to be stored in said storing means;

said second set of binary digits representing lower order address [Fig. 1 (C11-C21); Fig. 2 (C11-C23)] binary digits of a memory location in one of a plurality of subdivisions of said storing means; and characterized by:

said third set of binary digits representing higher order address [Fig. 1 (C22-C24)]; Fig. 2 (C24-C26)] binary digits identifying a particular one of said plurality of subdivisions of said storing means;

means [Figs. 1, 2 (30)] for selecting said one of said plurality of subdivisions as a function of the value of said third set of binary digits, said selecting means being connected in signal communication with said third set of connection points and said storing means; and

means [TABLE III] for defining a capacity value representing a preselected quantity of memory locations, said preselected quantity of memory locations being less than or equal to the total number of memory locations in said storing means.

10. A memory device, substantially as hereinbefore described with reference to and as illustrated in the accompanying drawings.

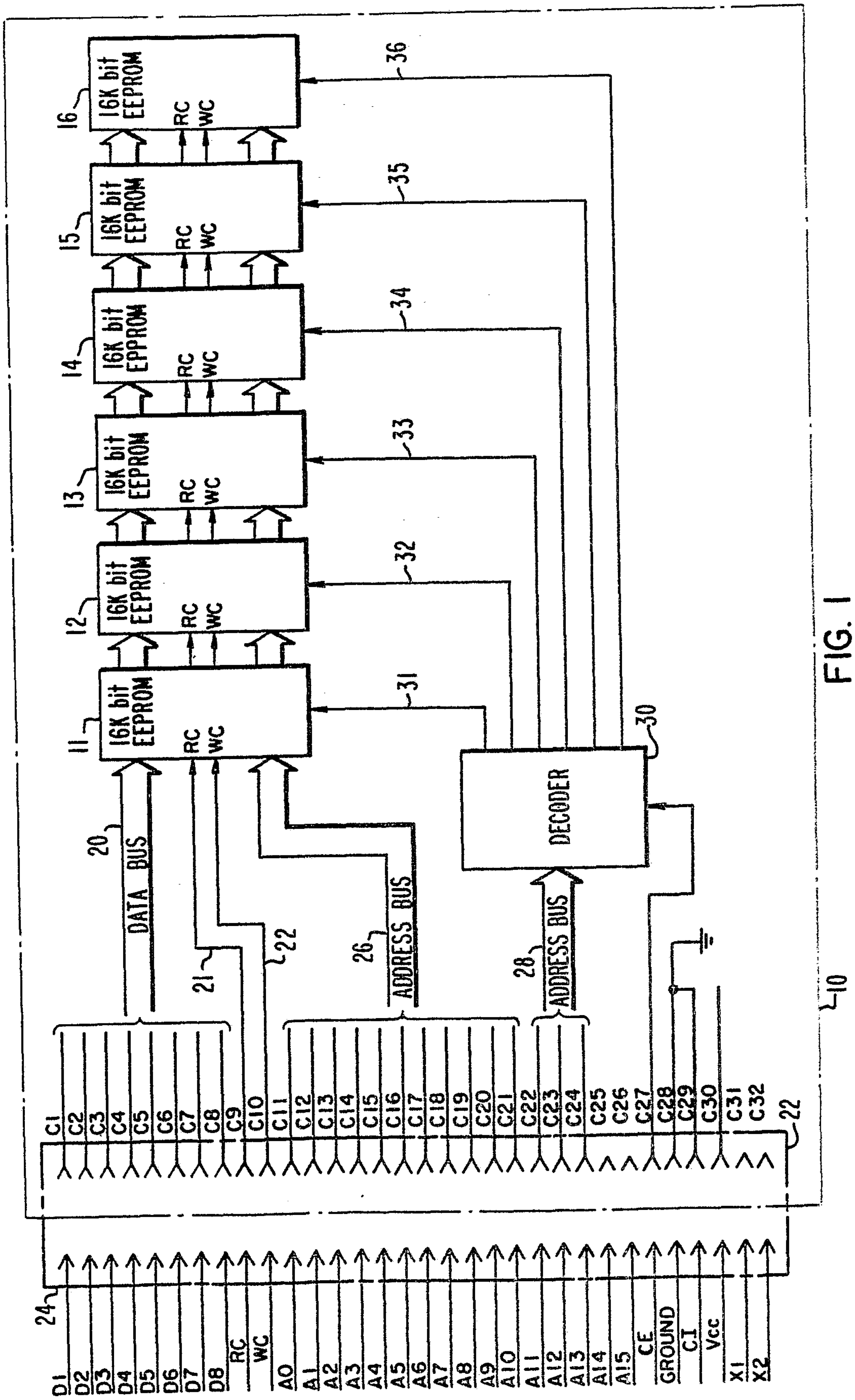
16K bit EEPROM
RC
WC
DECODER
DATA BUS
ADDRESS BUS
ADDRESS BUS
11
12
13
14
15
16
20
21
22
24
26
28
30
31
32
33
34
35
36
10
C1 C2 C3 C4 C5 C6 C7 C8 C9 C10 C11 C12 C13 C14 C15 C16 C17 C18 C19 C20 C21 C22 C23 C24 C25 C26 C27 C28 C29 C30 C31 C32
D1 D2 D3 D4 D5 D6 D7 D8 RC WC A0 A1 A2 A3 A4 A5 A6 A7 A8 A9 A10 A11 A12 A13 A14 A15 CE GROUND CI Vcc X1 X2

FIG. 1

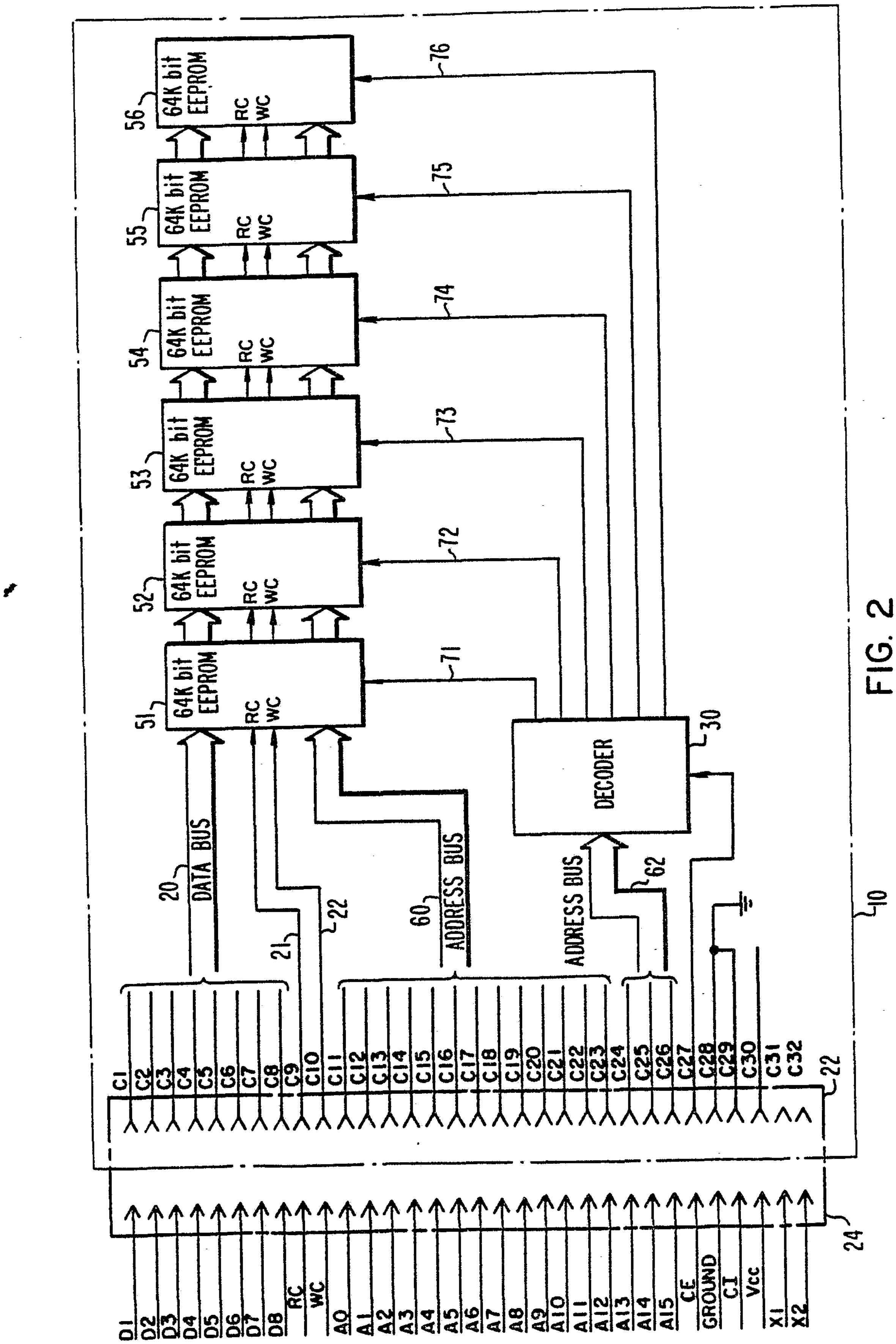
64K bit EEPROM
RC
WC
DATA BUS
ADDRESS BUS
DECODER
51
52
53
54
55
56
71
72
73
74
75
76
20
21
22
60
62
30
10
24
C1 C2 C3 C4 C5 C6 C7 C8 C9 C10 C11 C12 C13 C14 C15 C16 C17 C18 C19 C20 C21 C22 C23 C24 C25 C26 C27 C28 C29 C30 C31 C32
D1 D2 D3 D4 D5 D6 D7 D8 RC WC A0 A1 A2 A3 A4 A5 A6 A7 A8 A9 A10 A11 A12 A13 A14 A15 CE GROUND CI Vcc X1 X2

FIG. 2

0193306

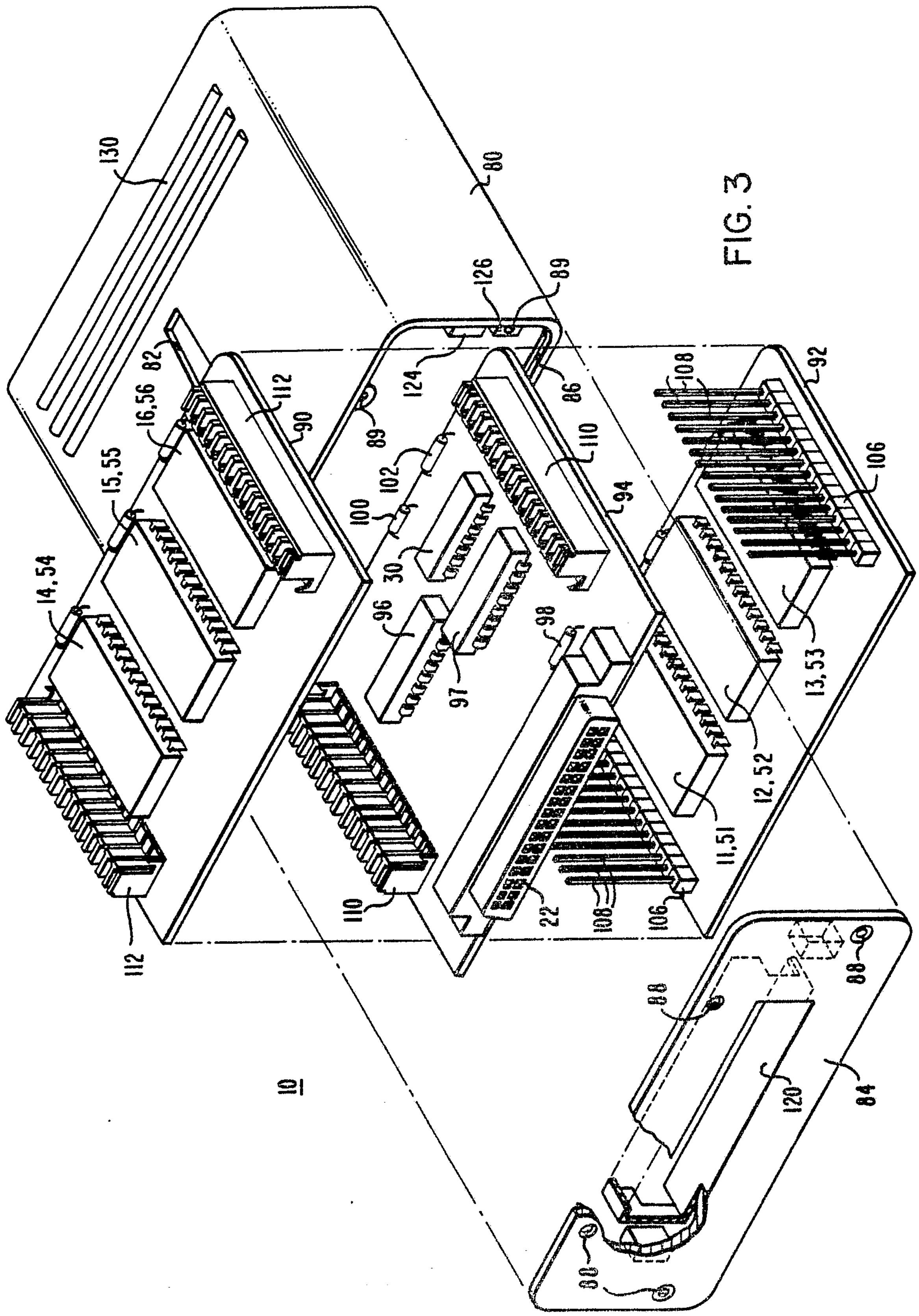


FIG. 3